# EUROPÄISCHE PATENTANMELDUNG

(11) **EP 1 626 387 A1**
(43) Veröffentlichungstag der Anmeldung: **15.02.2006**
(21) Anmeldenummer: 04018938.3
(22) Anmeldetag: 10.08.2004
(51) Int. Cl.: G09F 27/00, G06F 3/033, H03K 17/96

(54) **Präsentationssystem für Schaufenster**

(71) Anmelder: Zimmermann, Frank, 76706 Dettenheim (DE)
(72) Erfinder: Zimmermann, Frank, 76706 Dettenheim (DE)
(74) Vertreter: Mierswa, Klaus

(57) **Zusammenfassung**

Ein erfindungsgemäßes. Präsentationssystem umfasst eine EDV-Einrichtung mit Display und mit Näherungssensoren, welche hinter einer Schaufensterscheibe angeordnet sind. Jeder der Näherungssensoren ist imstande, auf die Annäherung z.B. eines vor der Schaufensterscheibe befindlichen Fingers kontaktlos anzusprechen, wobei die EDV-Einrichtung bei Ansprechen eines der Näherungssensoren erkennt, welcher Näherungssensor anspricht, und als Reaktion hierauf eine bestimmte Information zum Zwecke der Anzeige an das Display sendet. Gemäß einer alternativen Variante weist das erfindungsgemäße Präsentationssystem anstelle der Näherungssensoren einen hinter der Schaufensterscheibe angeordneten zonenweise ortsauflösenden Näherungssensor mit mindestens zwei Zonen auf, welche getrennt voneinander imstande sind, auf die Annäherung z.B. eines vor der Schaufensterscheibe befindlichen Fingers kontaktlos anzusprechen, wobei die EDV-Einrichtung bei Ansprechen einer der Zonen erkennt, welche der Zonen anspricht, und als Reaktion hierauf eine bestimmte Information zum Zwecke der Anzeige an das Display sendet.

## Beschreibung

### Stand der Technik:

Es ist bekannt, als Werbemittel zur Präsentation von Produkten oder Dienstleistungen in Ladengeschäften hinter Schaufensterscheiben Displays aufzustellen, auf welchem ein Werbetext angezeigt wird, der für sich außerhalb des Ladengeschäftes vor der Schaufensterscheibe aufhaltende Passanten lesbar ist. Insbesondere sind hierbei Werbetexte in Form von Laufschrift üblich. Ebenso ist es bekannt, in Schaufenstern Video-Monitore als Werbemittel aufzustellen, auf welchen ein Werbevideo wiedergegeben wird.

Ferner ist es bekannt, hinter Schaufensterscheiben computergesteuerte Monitore als Werbemittel aufzustellen, welche Werbeinformationen in Form von Text und/oder Grafik anzeigen. Diese Werbeinformationen werden mittels eines Computers, auf welchem ein eigens hierfür erstelltes Programm abläuft, erzeugt oder aus einem Speicher abgerufen und auf dem Monitor zur Anzeige gebracht.

Nachteilig bei diesen Werbemitteln ist, dass ein Betrachter vor der Schaufensterscheibe den Ablauf der Präsentation nicht beeinflussen kann. Insbesondere kann der Betrachter, dessen erstes Interesse durch diese Werbung geweckt ist, nicht erreichen, dass nähere Informationen zur Anzeige gelangen, wenn ihn ein bestimmter Aspekt des beworbenen Produkts besonders interessiert und er hierzu Details erfahren möchte. Wenn das Ladengeschäft geschlossen ist, bleibt dem Interessenten also nichts anderes übrig als zu einem anderen Zeitpunkt, nämlich wenn das Ladengeschäft wieder geöffnet ist, wiederzukommen oder anzurufen und bei einem Verkäufer oder dem Ladeninhaber nähere Auskünfte einzuholen. Falls der Verkäufer oder der Ladeninhaber nicht über die gewünschte nähere Information verfügen, kann sogar eine Rückfrage beim Hersteller oder Lieferanten erforderlich sein. Dieser Umstand bzw. der damit verbundene Aufwand und Zeitverlust wirkt sich in vielen Fällen negativ auf das Kaufinteresse des Interessenten aus.

Eine Beeinflussung des Systems durch den Interessenten kann z.B. dadurch ermöglicht werden, dass das System mit Tasten oder Drehknöpfen ausgestattet wird, welche durch den Interessenten betätigt werden können. Derartige Systeme werden z.B. in Form von Geldautomaten in Banken eingesetzt.

Jedoch ist es aufwendig, diese Systeme so zu modifizieren, dass sie hinter einer Schaufensterscheibe in einem Laden aufgestellt und dennoch von einem vor der Schaufensterscheibe außerhalb des Ladens stehenden Interessenten bedient werden können, da hierzu eine Durchführung der Bedienelemente nach außen sowie eine wasserdichte Kapselung derselben erforderlich ist. Die Installation derartiger Systeme ist daher mit irreversiblen Eingriffen wie etwa Bohrungen im Glas oder im Mauerwerk verbunden. Solchermaßen modifizierte Systeme eignen sich auf Grund des somit nötigen Installationsaufwandes hauptsächlich für den stationären Einsatz; der mobile Einsatz ist hingegen problematisch und in der Regel unwirtschaftlich.

Aus diesem Grund eignen sich solche modifizierten Systeme nicht dazu, z.B. an einen Ladeninhaber kurzzeitig vermietet zu werden, der das System nur vorübergehend, etwa für eine zeitlich begrenzte Werbeaktion, einsetzen möchte. Nach der Installation eines derartig modifizierten Systems ist ferner auch eine nachträgliche Optimierung der Position der Bedienelemente oder deren Anpassung an geänderte Anforderungen, z.B. die vorübergehende Anordnung der Bedienelemente in geringerer Höhe im Rahmen einer Werbeaktion für Kinder, kaum mehr möglich.

Der Nachteil der fehlenden Beeinflussbarkeit durch den Interessenten wird ferner auch durch so genannte Touch-Screens vermieden. Nachteilig an Touch-Sreens sind deren hohe Kosten und deren technische Komplexität, welche unter anderem durch die große Zahl der Eingabefelder von Touch-Screens bedingt ist; die Zahl der Eingabefelder beträgt typischerweise z.B. 1024 X 1024. Ein weiterer Nachteil von Touch-Screens besteht darin, dass zu ihrem Betrieb der zugehörige Computer nicht nur spezielle Software benötigt, sondern auch eine besondere Hardware-Erweiterung als Schnittstelle zwischen dem Computer und dem Touch-Screen.

Ein zusätzlicher, wesentlicher Nachteil von Touch-Screens ist der Umstand, dass die berührempfindliche Fläche des Touch-Screens für den Interessenten unmittelbar zugänglich sein muss, damit dieser die genannte Fläche mit seinen Fingern berühren kann. Es ist daher nicht möglich, einen Touch-Screen hinter einer Schaufensterscheibe in einem Ladengeschäft aufzustellen und ihn durch die Schaufensterscheibe hindurch von außerhalb des Ladengeschäftes zu bedienen.

Um von außerhalb des Ladengeschäftes bedient werden zu können, muss der Touch-Screen daher vor der Schaufensterscheibe anstatt dahinter angeordnet werden. Dies ist jedoch problematisch, da hierzu nicht nur Kabeldurchführungen ins Innere des Ladengeschäftes unter Inkaufnahme von bleibenden Änderungen wie z.B. Bohrungen im Glas erforderlich sind, sondern der Touch-Screen auch gegen Regen, Feuchtigkeit usw. geschützt werden muss und die Gefahr von Diebstahl oder mutwilliger Beschädigung der Zerstörung besteht. Ferner kann ein auf diese Weise installiertes Touch-Screen-System nicht mehr ohne großen Aufwand an einen anderen Einsatzort verbracht werden, da in diesem Fall neue Kabeldurchführungen und ggf. neue Diebstahlsicherungen usw. erforderlich sind, was einem mobilen Einsatz sehr störend entgegensteht.

Ein weiterer Nachteil von Touch-Screens besteht darin, dass die Position der berührempfindlichen Fläche an die Position des Monitors gebunden ist. Eine in Bezug auf den Monitor beliebige und somit jederzeit variable Anordnung der berührempfindlichen Fläche ist nicht möglich.

Der Erfindung liegt daher die Aufgabe zu Grunde, ein preiswertes, einfach zu installierendes Präsentationssystem für Schaufenster zu schaffen, welches von den genannten Nachteilen des Standes der Technik frei ist, sich insbesondere als Werbemittel eignet, in einem Ladengeschäft vollständig hinter einer Schaufensterscheibe angeordnet und dennoch von einem sich vor der Schaufensterscheibe außerhalb des Ladengeschäftes aufhaltenden Interessenten bedient oder beeinflusst werden kann, wobei der Standort des Präsentationssystems mit sehr geringem Aufwand, schnell und ohne bleibende Änderungen zu verursachen beliebig oft gewechselt werden kann und daher für mobilen Einsatz besonders geeignet ist, welches ferner ohne jeden zusätzlichen Schutz gegen Regen, Feuchte, Diebstahl oder Vandalismus auskommt, und welches darüber hinaus unter Verwendung eines handelsüblichen Standard-Personalcomputers mit einem handelsüblichren Standard-Monitor ohne die aufwendige Touch-Screen-Technologie betrieben werden kann.

Die Aufgabe wird erfindungsgemäß gelöst durch ein Präsentationssystem für Schaufenster, umfassend folgende Komponenten:
a) eine EDV-Einrichtung,
b) ein an die EDV-Einrichtung angeschlossenes Display, welches
   - imstande ist, von der EDV-Einrichtung an das Display gesandte Informationen anzuzeigen, und
   - hinter einer Schaufensterscheibe so anordbar ist, dass vom Display angezeigte Informationen von einem vor der Schaufensterscheibe gelegenen Ort aus ablesbar sind,
c) mindestens zwei ebenfalls an die EDV-Einrichtung angeschlossene Näherungssensoren, welche bezüglich des Displays in beliebiger Position außerhalb desselben hinter der Schaufensterscheibe anordbar sind und deren jeder bei Anordnung hinter der Schaufensterscheibe imstande ist, durch die Schaufensterscheibe hindurch auf die Annäherung einer vor der Schaufensterscheibe befindlichen Hand oder eines vor der Schaufensterscheibe befindlichen Fingers oder Gegenstandes, insbesondere Stabes, kontaktlos anzusprechen,

wobei die EDV-Einrichtung bei Ansprechen eines der Näherungssensoren imstande ist,zu erkennen, welcher der Näherungssensoren anspricht, und als Reaktion auf das Ansprechen dieses Näherungssensors eine bestimmte Information zum Zwecke der Anzeige an das Display zu senden.

Gemäß einer alternativen Ausführungsform weist das erfindungsgemäße Präsentationssystem anstelle der Näherungssensoren einen bezüglich des Displays in beliebiger Position außerhalb desselben hinter der Schaufensterscheibe anordbaren, an die EDV-Einrichtung angeschlossenen zonenweise ortsauflösenden Näherungssensor mit mindestens zwei Zonen aufweist, welche bei Anordnung des ortsauflösenden Näherungssensors hinter der Schaufensterscheibe getrennt voneinander imstande sind, durch die Schaufensterscheibe hindurch auf die Annäherung einer vor der Schaufensterscheibe befindlichen Hand oder eines vor der Schaufensterscheibe befindlichen Fingers oder Gegenstandes, insbesondere Stabes, kontaktlos anzusprechen, wobei die EDV-Einrichtung bei Ansprechen einer der Zonen imstande ist, zu erkennen, welche der Zonen anspricht, und als Reaktion auf das Ansprechen dieser Zone eine bestimmte Information zum Zwecke der Anzeige an das Display zu senden. Die Zonen brauchen weder linear in einer Linie angeordnet zu sein, noch braucht der ortslaufende Näherungssensor ein eindimensional ortsauflösener Näherungssensor zu sein. Der ortslaufende Näherungssensor kann daher z.B. ein zweidimensional ortsauflösener Näherungssensor sein.

Vorteilhafterweise ist die Anordnung der Sensoren bzw. des ortsauflösenden Sensors in Bezug auf das Display beliebig und daher jederzeit ohne weiteres nach Bedarf veränderbar. Bevorzugt sind die Sensoren von dem Display durch einen Zwischenraum räumlich beabstandet. Ebenso ist bei Verwendung eines ortsauflösenden Sensors dieser bevorzugt von dem Display durch einen Zwischenraum räumlich beabstandet. Beispielsweise kann sich das Display in Augenhöhe befinden, währen die Sensoren bzw. der ortsauflösende Sensor in einem Abstand darunter oder daneben angeordnet sind, so dass der zum Ansprechen der Sensoren benutzte Finger die Sicht auf das Display nicht beeinträchtigt.

Die Näherungssensoren bzw. der ortsauflösende Näherungssensor sind imstande, durch die Schaufensterscheibe hindurch auf die Annäherung der Hand oder des Fingers oder des Gegenstandes, der z.B. ein Stab wie ein Bleistift oder Kugelschreiber sein kann, anzusprechen, d.h. sie sprechen auf eine solche Annäherung an, obwohl sich zwischen den Näherungssensoren bzw. dem ortsauflösende Näherungssensor und der Hand oder dem Finger oder Stab die Schaufensterscheibe befindet. Ein Berührungskontakt oder ein elektrischer Kontakt zwischen den Näherungssensoren bzw. dem ortsauflösenden Näherungssensor und der Hand oder dem Finger oder Stab findet erfindungsgemäß hierbei nicht statt, d.h. die Näherungssensoren, bzw. der ortsauflösende Näherungssensor sind imstande, kontaktlos durch die Schaufensterscheibe hindurch auf die Annäherung der Hand oder des Fingers oder Stabes anzusprechen.

Derartige Näherungssensoren bzw. ortsauflösende Näherungssensoren sind im Handel erhältlich. Deren erfindungsgemäßer Einsatz macht die Verwendung der mit großem Aufwand und mit weiteren Nachteilen verbundenen Touch-Screen-Technologie überflüssig. Hierbei brauchen vorteilhafterweise die Sensoren bzw. der ortsauflösende Sensor mit dem Display nicht starr verbunden zu sein, so dass die räumliche Anordnung der Sensorsen bzw. des ortsauflösenden Sensors gegenüber dem Display jederzeit ohne Montageaufwand veränderbar ist. Gemäß einer bevorzugten Ausführungsform sind die Sensoren bzw. ist der ortsauflösende Sensor daher mit dem Display nicht starr verbunden, sondern von diesem mechanisch völlig unabhängig.

Ein wesentlicher Vorteil des erfindungsgemäßen Präsentationssystems besteht darin, dass sich dieses durch die Schaufensterscheibe hindurch kontaktlos bedienen läßt und daher vollständig hinter der Schaufensterscheibe innerhalb eines Ladengeschäftes befinden und über die Näherungssensoren bzw. den ortsauflösenden Näherungssensor dennoch von einem sich vor der Schaufensterscheibe aufhaltenden Passanten beeinflusst oder bedient werden kann. Kabeldurchführungen sind nicht erforderlich. Da kein Teil des Präsentationssystems nach außerhalb des Ladengeschäftes ragt oder sich außerhalb desselben befindet, kann auf alle zusätzlichen Maßnahmen zum Schutz des Präsentationssystems vor Regen, Feuchte, Schmutz, Diebstahl oder Vandalismus vollständig verzichtet werden. Je nach Bedarf können die Näherungssensoren bzw. der ortsauflösende Näherungssensor im Bereich der Schaufenster-Innenseite beliebig angeordnet werden, wobei die Anordnung jederzeit und beliebig oft variierbar ist.

Beispielsweise können die Näherungssensoren bzw. der ortsauflösende Näherungssensor mittels wenigstens eines Saugnapfes an der Schaufensterscheibe anordbar sein. Zur Veränderung ihrer Position braucht der Saugnapf dann lediglich von der Innenseite des Schaufensters gelöst und an einer anderen Stelle oder an einer anderen Schaufensterscheibe wieder angedrückt zu werden. Weitere Installationsmaßnahmen fallen nicht an, und es entstehen keinerlei bleibende Veränderungen. Auf diese Weise kann die Position der Näherungssensoren bzw. des ortsauflösenden Näherungssensors jederzeit mit wenigen Handgriffen optimiert oder z.B. an geänderte Anforderungen angepasst werden.

Die EDV-Einrichtung ist vorzugsweise ein Computer, beispielsweise ein PC. Der PC kann insbesondere ein handelsüblicher Standard-PC sein. Ebenso kann das Display insbesondere ein handelsüblicher Standard-Monitor sein. In der EDV-Einrichtung ist vorzugsweise ein EDV-Programm installiert, welches die an das Display gesandte Information auszuwählen, zu bestimmen oder zu verändern imstande ist, wobei der Ablauf des EDV-Programms bei Ansprechen eines der Näherungssensoren bzw. einer der Zonen in Abhängigkeit davon, welcher der Näherungssensoren bzw. welche der Zonen anspricht, in vorgegebener Weise beeinflussbar oder veränderbar ist.

Der Benutzer kann von einem Standort vor der Schaufensterscheibe außerhalb des Ladengeschäftes mittels entsprechender Positionierung eines seiner Finger oder seiner Hand und dadurch gezielt ausgelöstes Ansprechen eines bestimmten Näherungssensors bzw. einer bestimmten Zone des ortsauflösenden Näherungssensors Eingaben vornehmen, welche das Präsentationssystem und die auf dem Display angezeigte Information beeinflussen.

Bevorzugt ist die EDV-Einrichtung imstande, bei Ansprechen eines bestimmten der Näherungssensoren in einen bestimmten Primärzustand zu wechseln, in welchem die EDV-Einrichtung eine bestimmte Primärinformation an das Display sendet. Der Benutzer kann in diesem Fall jederzeit durch eine einzige Eingabe das Präsentationssystem in den Primärzustand bringen, beispielsweise um eine Suche nach einer bestimmten Information von vorn beginnen zu können, ohne zunächst durch zahlreiche Eingaben den Primärzustand herbeiführen zu müssen. Der Primärzustand ist bevorzugt ein solcher Zustand, welchen das Präsentationssystem nach dessen Einschalten von selbst zunächst einnimmt.

Die EDV-Einrichtung ist bevorzugt ferner imstande, bei Ansprechen eines der übrigen Näherungssensoren in jeweils einen von einer Vielzahl bestimmter Sekundärzustände zu wechseln, in welchem die EDV-Einrichtung jeweils eine bestimmte Sekundärinformation an das Display sendet. Beispielsweise können ein oder eine Mehrzahl von auf dem Display anzeigbaren Auswahlmenüs vorgesehen sein, durch welche sich der Benutzer mittels entsprechender Eingaben zu einer bestimmten von ihm gewünschten Information vorarbeiten kann, wobei jede dieser Eingaben zu einem der Sekundärzustände führt. Selbstverständlich kann ein Auswahlmenü zu einem Untermenü usw. führen, wie dies z.B. auch aus dem Internet bekannt ist.

Der Inhalt der an das Display gesandten Information kann z.B, eine Beschreibung und/oder Darstellung einer Ware oder Dienstleistung umfassen. Der Inhalt der an das Display gesandten Information kann ferner z.B. ein Angebot zum Kauf der Ware oder zur Inanspruchnahme der Dienstleistung oder Werbung für die Ware oder Dienstleistung umfassen.

Die Näherungssensoren können insbesondere kapazitive oder induktive oder optische oder akustische oder auf Infrarotstrahlung reagierende Näherungssensoren sein. Ebenso kann der ortsauflösende Näherungssensor ein kapazitiver oder induktiver oder optischer oder akustischer oder auf Infrarotstrahlung reagierender Näherungssensor sein.

Gemäß einer bevorzugten Ausgestaltung der Erfindung ist zwischen den Näherungssensoren und der Schaufensterscheibe bzw. zwischen den Zonen des ortsauflösenden Näherungssensors und der Schaufensterscheibe eine Maske angeordnet, welche mindestens eine von einem vor der Schaufensterscheibe gelegenen Ort aus sichtbare Markierung trägt. Die Markierung, welche z.B. als Text, als Symbol oder als Piktogramm ausgebildet sein kann, dient vorzugsweise dazu, den Benutzer des Präsentationssystems auf die bestehenden Eingabemöglichkeiten hinzuweisen, sowie den Bereich anzuzeigen, in welchen der Benutzer einen Finger oder eine Hand bewegen muss, um die Eingabe tätigen zu können. Alternativ hierzu kann die Maske M weggelassen werden und stattdessen die einzelnen Näherungssensoren selbst oder ein Teil von ihnen z.B. mit Symbolen beschriftet sein. Gemäß einer weiteren alternativen Ausführungsform sind die Markierungen einzeln. d.h. ohne gemeinsam auf einer Maske angeordnet zu sein, zwischen den Näherungssensoren und der Schaufensterscheibe bzw. zwischen den Zonen des ortsauflösenden Näherungssensors und der Schaufensterscheibe angeordnet.

Bevorzugt ist hierbei die Anzahl der Markierungen gleich der Anzahl der Näherungssensoren, wobei im Erfassungsbereich jedes derselben genau eine der Markierungen angeordnet ist, so dass zu jedem Näherungssensor genau eine Markierung gehört, und jede Markierung durch einen Hinweis oder ein Symbol für die Art der Reaktion der EDV-Einrichtung gebildet, welche bei Ansprechen des zu der Markierung gehörenden Näherungssensors erfolgt. Gemäß einer alternativen Variante ist die Anzahl der Markierungen gleich der Anzahl der Zonen des ortsauflösenden Näherungssensors, wobei im Erfassungsbereich jeder derselben genau eine der Markierungen angeordnet ist, so dass zu jeder Zone genau eine Markierung gehört, und jede Markierung durch einen Hinweis oder ein Symbol für die Art der Reaktion der EDV-Einrichtung gebildet, welche bei Ansprechen des zu der Markierung gehörenden Zone erfolgt. Die Markierungen dienen somit bevorzugt als Eingabehilfen für den Benutzer.

Die Maske wird vorzugsweise an die Innenseite des Schaufensters angelegt oder aufgeklebt und kann z.B. aus Papier oder aus Plastik bestehen, auf welches die Markierungen aufgedruckt sind. Gemäß einer anderen Variante ist die Maske ein Flachbildschirm, auf welchem die Markierung oder die Markierungen dargestellt sind. In diesem Fall können die Markierungen softwaremäßig beliebig verändert werden.

Das Display kann z.B. ein LCD-Bildschirm oder ein Plasmabildschirm oder ein sonstiger Flachbildschirm oder ein Kathodenstrahl-Bildschirm oder ein Beamer sein. Insbesondere kann daher auch das Display ein Flachbildschirm sein. Hierbei können insbesondere das Display und die Maske durch ein- und denselben Flachbildschirm gebildet sein. Beispielsweise kann das untere Drittel des Flachbildschirms als Maske fungieren und die oberen zwei Drittel desselben als Display zur Anzeige der von der EDV-Einrichtung gesandten Information.

Gemäß einer weiteren vorteilhaften Ausgestaltung des erfindungsgemäßen Präsentationssystems ist an die EDV-Einrichtung ferner ein Lautsprecher angeschlossen, wobei die EDV-Einrichtung zusätzlich imstande ist den Lautsprecher zu veranlassen, ein von einem Ort vor der Schaufensterscheibe hörbares akustisches Signal abzugeben, welches der an von der EDV-Einrichtung an das Display gesandten Information zugeordnet ist. Das akustische Signal kann insbesondere ein Ansagetext, ein Geräusch oder Musik sein.

Die Näherungssensoren bzw. Zonen können voneinander so beabstandet sein, dass sich zwischen den Näherungssensoren bzw. Zonen unempfindliche Bereiche befinden, welche nicht auf die Annäherung eines Fingers oder Gegenstandes oder einer Hand ansprechen. Um eindeutige Eingaben zu gewährleisten, d.h ein unbeabsichtigtes gleichzeitiges Ansprechen mehrerer Näherungssensoren bzw. Zonen auszuschließen, sind bevorzugt die Näherungssensoren bzw. die Zonen jeweils durch Zwischenräume voneinander beabstandet, wobei die Zwischenräume so groß gewählt sind, dass durch ein- und denselben Finger oder ein- und dieselbe Hand jeweils höchstens einer der Näherungssensoren bzw. jeweils höchstens eine der Zonen zum Ansprechen gebracht werden kann.

Gemäß einer bevorzugten Ausführungsform ist die Anzahl der Näherungssensoren bzw. die Anzahl der Zonen kleiner als zehn. Für Werbezwecke genügt in den meisten Fällen bereits eine Anzahl von fünf Näherungssensoren oder fünf Zonen, um dem Benutzer eine einfache und übersichtliche, aber dennoch ausreichend differenzierte Bedienung des Präsentationssystems zu ermöglichen.

Kurzbeschreibung der Zeichnung, in welcher schematisch zeigen:
- Fig. 1: eine Seitenansicht einer Ausführungsform eines erfindungsgemäßen Präsentationssystems,
- Fig.2: eine Seitenansicht einer anderen Ausführungsform eines erfindungsgemäßen Präsentationssystems, und
- Fig. 3: eine Maske mit Markierungen als Eingabehilfe für einen Benutzer eines erfindungsgemäßen Präsentationssystems.

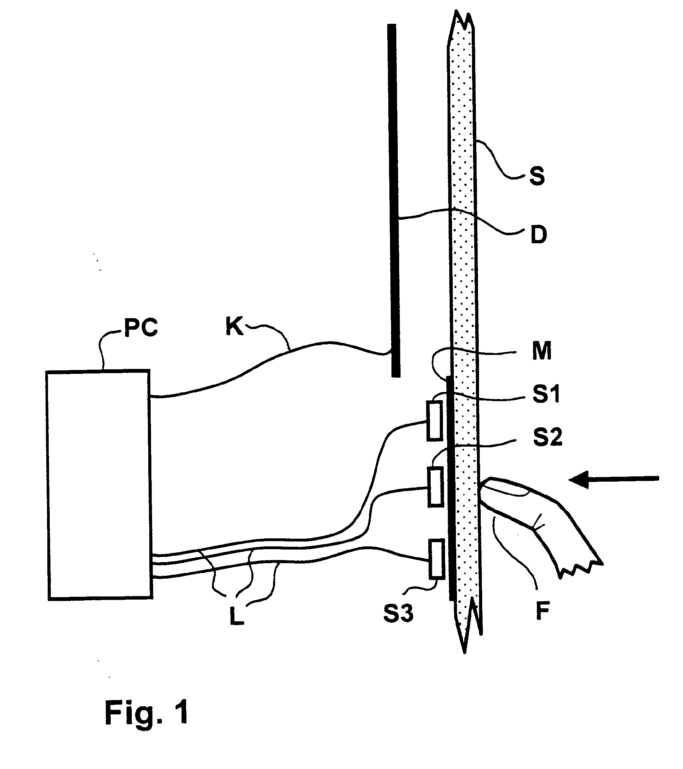

Fig. 1 zeigt eine Ausführungsform eines erfindungsgemäßen Präsentationssystems für Schaufenster mit einer EDV-Einrichtung PC, welche im Beispiel von Fig. 1 als Standard-Personalcomputer PC ausgebildet und hinter einer Schaufensterscheibe S angeordnet ist. An den Personalcomputer PC ist ein Display D angeschlossen, welches im Beispiel von Fig. 1 als Standard-Flachmonitor D ausgebildet ist. Das Display D ist ebenfalls hinter der Schaufensterscheibe S angeordnet und imstande, von dem Personalcomputer PC über ein Kabel K an das Display D gesandte Informationen anzuzeigen. Das Display D ist hierbei so angeordnet, dass vom Display angezeigte Informationen von einem vor der Schaufensterscheibe S gelegenen Ort aus ablesbar sind. Das Display D kann z.B. mittels eines Saugnapfes an der Innenseite der Schaufensterscheibe S aufgehängt sein.

Ferner ist hinter der Schaufensterscheibe S eine über Leitungen L ebenfalls an den Personalcomputer PC angeschlossene Sensorgruppe angeordnet. Diese befindet sich außerhalb des Displays D in einem Abstand von demselben und ist kein Bestandteil des Displays D. Die Sensorgruppe besteht im Beispiel von Fig. 1 aus fünf Näherungssensoren S1,S2,S3,S4,S5, wovon in Fig. 1 jedoch nur die Näherungssensoren S1,S2,S3 sichtbar sind; die übrigen Näherungssensoren S4,S5 befinden sich in Fig. 1 hinter den Näherungssensoren S2 bzw. S3 und sind somit in Fig. 1 verdeckt.

Jeder der Näherungssensoren S1,S2,S3,S4,S5 ist imstande, durch die Schaufensterscheibe S hindurch und somit kontaktlos auf die Annäherung eines vor der Schaufensterscheibe S befindlichen Fingers F eines nicht gezeigten, sich vor der Schaufensterscheibe S aufhaltenden Benutzers anzusprechen. Derartige Näherungssensoren sind im Handel erhältlich. Im Beispiel von Fig. 1 befindet sich der Finger F im Erfassungsbereich des Näherungssensors S2, so dass dieser anspricht. Der Finger F braucht hierfür die Schaufensterscheibe S nicht notwendigerweise zu berühren.

Vorteilhafterweise ist die Anordnung der Sensoren S1,S2,S3,S4,S5 in Bezug auf das Display D beliebig und daher jederzeit ohne weiteres nach Bedarf veränderbar. Daher kann z.B. das Display hinter der Schaufensterscheibe S von dieser entfernt auf einem Tisch stehen, während die Sensoren S1,S2,S3,S4,S5 an der Innenseite der Schaufensterscheibe S befestigt sein können. Auch die gegenseitige Anordnung der Sensoren S1,S2,S3,S4,S5 in Bezug aufeinander ist beliebig und daher jederzeit ohne weiteres nach Bedarf veränderbar.

Der Personalcomputer PC ist bei Ansprechen eines der Näherungssensoren S1,S2,S3,S4,S5 imstande zu erkennen, welcher der Näherungssensoren S1, S2,S3,S4,S5 anspricht, und als Reaktion auf das Ansprechen dieses Näherungssensors S1,S2,S3,S4,S5 eine bestimmte Information zum Zwecke der Anzeige an das Display D zu senden. Diese Information kann z.B. in eine Abbildung einer zum Verkauf angebotenen Ware sein.

Das Einführen des Fingers F in den Erfassungsbereich eines der Näherungssensoren S1,S2,S3,S4,S5 stellt also eine kontaktlose Eingabe des Benutzers in das Präsentationssystem durch die Schaufensterscheibe S hindurch dar.

Wenn der Benutzer den Finger F aus dem Erfassungsbereich des Näherungssensors S2 entfernt und danach erneut in den Erfassungsbereich des Näherungssensors S2 oder in den Erfassungsbereich eines der anderen Näherungssensoren S1,S3,S4,S5 bewegt, spricht der betreffende Näherungssensor an mit der Folge, dass der Personalcomputer PC wiederum eine Information an das Display D sendet, z.B. eine vergrößerte Detailansicht der Ware.

Um in der genannten Weise auf Eingaben des Benutzers reagieren zu können, ist in dem Personalcomputer PC ein EDV-Programm installiert, welches die an das Display D gesandte Information in Abhängigkeit von den durch die Schaufensterscheibe S hindurch getätigten kontaktlosen Eingaben auszuwählen, zu bestimmen oder zu verändern imstande ist. Beispielsweise kann das EDV-Programm eine Menüartige Benutzerführung vorsehen, mittels welcher sich der Benutzer systematisch durch entsprechende Eingaben zu einer individuell von ihm gewünschten Information vorarbeiten kann.

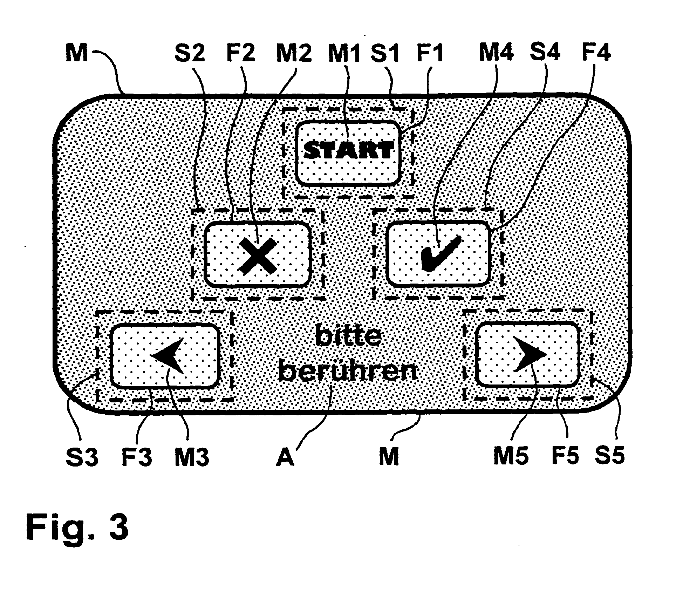

Um dem Benutzer sinnvolle Eingaben zu Erleichtern, ist zwischen den Näherungssensoren S1,S2,S3,S4,S5 und der Schaufensterscheibe S eine Maske M angeordnet, welche mehrere von einem für den Benutzer sichtbare Markierungen trägt. Ein Beispiel für eine derartige Maske M ist in Fig. 3 in Draufsicht gezeigt, wobei die Blickrichtung der Draufsicht der Richtung des Pfeils von Figur 1 entspricht.

Die Maske M von Fig. 3 kann z.B. aus Papier oder einem Kartonstück oder einem Stück Plastikfolie bestehen, welches an der Innenseite der Schaufensterscheibe S z.B. mit Klebestreifen oder auf andere Weise lösbar befestigt ist. Die Näherungssensoren S1,S2,S3,S4,S5 können direkt auf die Rückseite der Maske M aufgeklebt sein. Bevorzugt sind die Näherungssensoren S1,S2,S3,S4,S5 jedoch mittels Saugnäpfen lösbar an der Innenseite des Schaufensters S befestigt.

Die Markierung M weist an ihrer Vorderseite fünf farblich abgesetzte Felder F1,F2,F3,F4,F5 auf. Im Feld F1 befindet sich eine Markierung M1, im Feld F2 eine Markierung M2, usw., wobei sich jede der Markierung in der Blickrichtung der Draufsicht von Fig. 3 vor genau einem der Näherungssensoren S1,S2,S3,S4,S5 befindet.

Die Anzahl der Markierungen M1,M2,M3,M4,M5 ist gleich der Anzahl der Näherungssensoren S1,S2,S3,S4,S5. Im Erfassungsbereich jedes derselben ist genau eine der Markierungen M1,M2,M3,M4,M5 angeordnet ist, so dass zu jedem Näherungssensor S1,S2,S3,S4,S5 genau eine Markierung M1,M2,M3, M4,M5 gehört.

Die Markierung M1 befindet sich hierbei, bezogen auf die Richtung des Pfeils von Fig. 1, vor dem Näherungssensor S1, die Markierung M2 vor dem Näherungssensor S2, usw., so dass jede Markierung M1,M2,M3,M4,M5 ein-eindeutig einem der Näherungssensoren S1,S2,S3,S4,S5 zugeordnet ist. Die in Fig. 3 von der Maske M verdeckten, hinter derselben angeordneten Näherungssensoren S1,S2,S3,S4,S5 sind in Fig. 3 aus Gründen der Anschaulichkeit gestrichelt eingezeichnet. Jede der Markierungen M1,M2,M3,M4,M5 ist ein Hinweis oder ein Symbol für die Art der Reaktion des Personalcomputers PC, welche bei Ansprechen des zu der Markierung M1,M2,M3,M4,M5 gehörenden Näherungssensors S1,S2,S3,S4,S5 erfolgt.

Um eindeutige Eingaben zu gewährleisten, d.h ein unbeabsichtigtes gleichzeitiges Ansprechen von mehr als einem der Näherungssensoren S1,S2, S3,S4,S5 auszuschließen, sind diese vorzugsweise jeweils durch so große Zwischenräume voneinander beabstandet, dass durch ein- und denselben Finger F jeweils höchstens einer der Näherungssensoren S1,S2,S3, S4,S5 zum Ansprechen gebracht werden kann. Die Näherungssensoren S1,S2,S3,S4,S5 können selbstverständlich zum Zweck der leichteren Handhabung mechanisch starr oder flexibel miteinander verbunden sein; beispielsweise können sie auf einem gemeinsamen Träger montiert sein.

Im Beispiel von Fig. 3 trägt die Maske M eine zusätzliche, keinem Näherungssensor zugeordnete Aufschrift A, welche eine allgemeine Aufforderung des Interessenten zur Benutzung des erfindungsgemäßen Präsentationssystems darstellt. Selbstverständlich kann die Maske M weitere zusätzliche Aufschriften tragen, z.B. eine Telefonnummer, eine Internet-Adresse, ein Bild oder einen Hinweis auf den Eigentümer des Präsentationssystems.

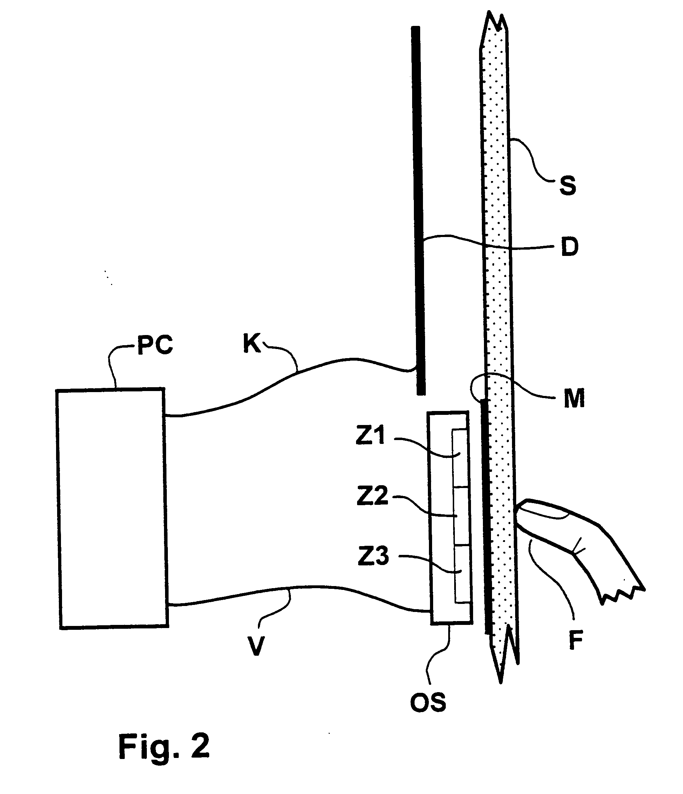

Fig.2 zeigt eine Seitenansicht einer anderen Ausführungsform eines erfindungsgemäßen Präsentationssystems, welche sich von derjenigen von Fig. 1 dadurch unterscheidet, dass sie anstelle der Näherungssensoren S1,S2,S3,S4,S5 einen außerhalb des Displays D hinter der Schaufensterscheibe S angeordneten, an den Personalcomputer PC angeschlossenen zonenweise ortsauflösenden Näherungssensor OS mit drei Zonen Z1,Z2,Z3 aufweist, welche getrennt voneinander imstande sind, auf die Annäherung des vor der Schaufensterscheibe S befindlichen Fingers F durch die Schaufensterscheibe S hindurch kontaktlos anzusprechen, wobei der Personalcomputer PC bei Ansprechen einer der Zonen Z1,Z2,Z3 imstande ist, zu erkennen, welche der Zonen Z1,Z2,Z3 anspricht, und als Reaktion auf das Ansprechen dieser Zone Z1,Z2,Z3 eine bestimmte Information zum Zwecke der Anzeige an das Display D zu senden. Zur seriellen Datenübertragung besteht zwischen dem orstauflösenden Näherungssensor OS und dem Personalcomputer PC eine Verbindung V, welche die Leitungen L von Fig. 1 ersetzt.

Die Erfindung stellt gemäß einer bevorzugten Ausführungsform ein datenbankgestütztes, interaktives System zur professionellen Präsentation von Waren und Artikeln in Schaufenstern dar. Das erfindungsgemβe Präsentationssystem besteht bevorzugt aus einem Rechner, einem Bildschirm oder sonstigen Display beliebiger Größe und einer kontaktlos, nämlich kapazitiv arbeitenden Sensortastatur.

Die dazugehörige Software besteht bevorzugt aus drei zusammenwirkenden Modulen: die Datenbank, die alle Informationen speichert, die Präsentationssoftware (der 'Kiosk'), die die Daten für die Kunden aufbereitet widergibt, und die Administrationssoftware, die die Bestückung der Datenbank, das Erscheinungsbild der Präsentationssoftware sowie das Verhalten der Recheneinheit regelt.

### Aufbau und Funktionsweise gemäß einer bevorzugten Ausführungsform:

Das System wird z.B. wie in Fig.1 gezeigt aufgebaut. Die einzelnen Komponenten werden durch Kabel verbunden, wobei der Rechner verdeckt aufgestellt werden kann. Z.B. mittels Saugnäpfen kann die Sensortastatur vandalismusgeschützt auf der Innenseite der Schaufensterverglasung bzw. Schaufensterscheibe angebracht werden.

Die kapazitiv arbeitenden Näherungssensoren ermöglichen eine Steuerung des Rechners durch die Verglasung des Schaufensters hindurch: Der Benutzer kann gezielt Produkte und Informationen seines Interesses auswählen.

Die Datenbank liefert entsprechend der kontaktlosen Eingaben des Benutzers z.B. Produktinformationen und/oder digitalisierte Fotografien des jeweiligen Artikels zurück und bringt dies auf dem Bildschirm zur Anzeige. Dieser kann z.B. ein Kathodenstrahlbildschirm, ein Beamer oder ein Flachbildschirm wie z.B. ein LCD-Bildschirm oder ein Plasmabildschirm sein.

### Steuerung gemäß einer bevorzugten Ausführungsform:

Fig.3 zeigt die Frontansicht einer Maske M für die der Sensortastatur mit den fünf Bedienungstasten bzw. kontaktlosen Eingabefeldern F1 bis F5, welche die fünf Eingaben "LINKS" (Feld F3), "RECHTS" (Feld F5), "POSITIV" (Feld F4), "NEGATIV" (Feld F2) und "START" (Feld F1) ermöglichen.

Die durch Annäherung des Fingers F an das Feld F1 mögliche kontaktlose Eingabe "START" dient zur Rückkehr auf die oberste Ebene, von der aus der Benutzer durch verschiedene Unterebenen durch den 'Verzeichnisbaum' bis hin zur gewünschten Information navigieren kann. Die durch Annäherung des Finger F an die Felder F3 bzw. F5 möglichen kontaktlosen Eingaben "LINKS" bzw. "RECHTS2 ermöglichen das Bewegen innerhalb einer Gruppe von Auswahlmöglichkeiten sowie das Fokussieren eines beliebigen Objektes innerhalb dieser Gruppe. Die durch Annäherung des Fingers F an das Feld F4 mögliche kontaktlose Eingabe "POSITIV' bewirkt, daß eine spezifische Auswahl getroffen und bestätigt wird, z.B. das Öffnen einer Artikelgruppe. Die durch Annäherung des Fingers F an das Feld F2 mögliche kontaktlose Eingabe "NEGATIV" entspricht einer Verneinung und ermöglicht das Abbrechen einer Aktion bzw. die Rückkehr zu einer übergeordneten Ebene.

### Gewerbliche Anwendbarkeit:

Die Erfindung ist gewerblich anwendbar insbesondere im Bereich der Werbung und der Öffentlichkeitsarbeit.

### Liste der Bezugszeichen:

- D: Display
- F: Finger
- F1 bis F5: erstes bis fünftes Feld auf M
- K: Kabel
- L: Leitungen
- M: Maske
- M1 bis M5: erste bis fünfte Markierung auf M
- OS: ortsauflösender Näherungssensor
- PC: Rechner
- S: Schaufensterscheibe
- S1 bis S5: erster bis fünfter Näherungssensor
- V: Verbindung
- Z1, Z2, Z3: erste, zweite, dritte Zone von OS

## Patentansprüche

1. Präsentationssystem für Schaufenster, umfassend folgende Komponenten:
a) eine EDV-Einrichtung (PC),
b) ein an die EDV-Einrichtung (PC) angeschlossenes Display (D), welches
- imstande ist, von der EDV-Einrichtung (PC) an das Display (D) gesandte Informationen anzuzeigen, und
- hinter einer Schaufensterscheibe (S) so anordbar ist, dass vom Display (D) angezeigte Informationen von einem vor der Schaufensterscheibe (S) gelegenen Ort aus ablesbar sind,
c) mindestens zwei ebenfalls an die EDV-Einrichtung (PC) angeschlossene Näherungssensoren (S1,S2,S3,S4,S5), welche bezüglich des Displays (D) in beliebiger Position außerhalb desselben hinter der Schaufensterscheibe (S) anordbar sind und deren jeder bei Anordnung hinter der Schaufensterscheibe (S) imstande ist, durch die Schaufensterscheibe (S) hindurch auf die Annäherung einer vor der Schaufensterscheibe (S) befindlichen Hand oder eines vor der Schaufensterscheibe (S) befindlichen Fingers (F) oder Gegenstandes, insbesondere Stabes, kontaktlos anzusprechen,
wobei die EDV-Einrichtung (PC) bei Ansprechen eines der Näherungssensoren (S1,S2,S3,S4,S5) imstande ist,
- zu erkennen, welcher der Näherungssensoren (S1,S2,S3,S4,S5) anspricht, und
- als Reaktion auf das Ansprechen dieses Näherungssensors (S1,S2,S3, S4,S5) eine bestimmte Information zum Zwecke der Anzeige an das Display (D) zu senden.

2. Präsentationssystem nach Anspruch 1, **dadurch gekennzeichnet,**
**dass** dasselbe anstelle der Näherungssensoren (S1,S2,S3,S4,S5) einen bezüglich des Displays (D) in beliebiger Position außerhalb desselben hinter der Schaufensterscheibe (S) anordbaren, an die EDV-Einrichtung (PC) angeschlossenen zonenweise ortsauflösenden Näherungssensor (OS) mit mindestens zwei Zonen (Z1,Z2,Z3) aufweist, welche bei Anordnung des ortsauflösenden Näherungssensors (OS) hinter der Schaufensterscheibe (S) getrennt voneinander imstande sind, durch die Schaufensterscheibe (S) hindurch auf die Annäherung einer vor der Schaufensterscheibe (S) befindlichen Hand oder eines vor der Schaufensterscheibe (S) befindlichen Fingers oder Gegenstandes, insbesondere Stabes, kontaktlos anzusprechen, wobei die EDV-Einrichtung (PC) bei Ansprechen einer der Zonen (Z1,Z2,Z3) imstande ist,
- zu erkennen, welche der Zonen (Z1,Z2,Z3) anspricht, und
- als Reaktion auf das Ansprechen dieser Zone (Z1,Z2,Z3) eine bestimmte Information zum Zwecke der Anzeige an das Display (D) zu senden.

3. Präsentationssystem nach Anspruch 1 oder 2, **dadurch gekennzeichnet,**
**dass** in der EDV-Einrichtung (PC) ein EDV-Programm installiert ist, welches die an das Display (D) gesandte Information auszuwählen, zu bestimmen oder zu verändern imstande ist, wobei der Ablauf des EDV-Programms bei Ansprechen eines der Näherungssensoren (S1,S2,S3,S4,S5) bzw. einer der Zonen (Z1,Z2,Z3) in Abhängigkeit davon, welcher der Näherungssensoren (S1,S2,S3,S4,S5) bzw. welche der Zonen (Z1,Z2,Z3) anspricht, in vorgegebener Weise beeinflussbar oder veränderbar ist.

4. Präsentationssystem nach einem der Ansprüche 1 bis 3, **dadurch gekennzeichnet,**
**dass** der Inhalt der an das Display (D) gesandten Information eine Beschreibung und/oder Darstellung einer Ware oder Dienstleistung umfasst.

5. Präsentationssystem nach Anspruch 4, **dadurch gekennzeichnet,**
**dass** der Inhalt der an das Display (D) gesandten Information ferner ein Angebot zum Kauf der Ware oder zur Inanspruchnahme der Dienstleistung oder Werbung für die Ware oder Dienstleistung umfasst.

6. Präsentationssystem nach einem der Ansprüche 1 bis 5, **dadurch gekennzeichnet,**
**dass** die EDV-Einrichtung (PC) imstande ist, bei Ansprechen eines bestimmten der Näherungssensoren (S1) in einen bestimmten Primärzustand zu wechseln, in welchem die EDV-Einrichtung (PC) eine bestimmte Primärinformation an das Display (D) sendet.

7. Präsentationssystem nach Anspruch 6, **dadurch gekennzeichnet,**
**dass** die EDV-Einrichtung (PC) imstande ist, bei Ansprechen eines der übrigen Näherungssensoren (S2,S3,S4,S5) in jeweils einen von einer Vielzahl bestimmter Sekundärzustände zu wechseln, in welchem die EDV-Einrichtung (PC) jeweils eine bestimmte Sekundärinformation an das Display (D) sendet.

8. Präsentationssystem nach einem der Ansprüche 1 bis 7, **dadurch gekennzeichnet,**
**dass** die Näherungssensoren (S1,S2,S3,S4,S5) kapazitive oder induktive oder optische oder akustische oder auf Infrarotstrahlung reagierende Näherungssensoren sind bzw. der ortsauflösende Näherungssensor (OS) ein kapazitiver oder induktiver oder optischer oder akustischer oder auf Infrarotstrahlung reagierender Näherungssensor ist.

9. Präsentationssystem nach einem der Ansprüche 1 bis 8, **dadurch gekennzeichnet,**
**dass** zwischen den Näherungssensoren (S1,S2,S3,S4,S5) und der Schaufensterscheibe (S) bzw. zwischen den Zonen (Z1,Z2,Z3) und der Schaufensterscheibe (S) eine Maske (M) angeordnet ist, welche mindestens eine von einem vor der Schaufensterscheibe (S) gelegenen Ort aus sichtbare Markierung (M1,M2,M3,M4,M5) trägt.

10. Präsentationssystem nach Anspruch 9, **dadurch gekennzeichnet, dass**
- die Anzahl der Markierungen (M1,M2,M3,M4,M5) gleich der Anzahl der Näherungssensoren (S1,S2,S3,S4,S5) ist und im Erfassungsbereich jedes derselben genau eine der Markierungen (M1,M2,M3,M4,M5) angeordnet ist, so dass zu jedem Näherungssensor (S1,S2,S3,S4,S5) genau eine Markierung (M1,M2,M3,M4,M5) gehört, und jede Markierung (M1,M2,M3,M4,M5) durch einen Hinweis oder ein Symbol für die Art der Reaktion der EDV-Einrichtung (PC) gebildet ist, welche bei Ansprechen des zu der Markierung (M1,M2,M3,M4,M5) gehörenden Näherungssensors (S1,S2,S3,S4,S5) erfolgt,
- bzw. die Anzahl der Markierungen gleich der Anzahl der Zonen (Z1,Z2,Z3) ist und im Erfassungsbereich jeder derselben genau eine der Markierungen angeordnet ist, so dass zu jeder Zone (Z1,Z2,Z3) genau eine Markierung gehört, und jede Markierung durch einen Hinweis oder ein Symbol für die Art der Reaktion der EDV-Einrichtung (PC) gebildet ist, welche bei Ansprechen des zu der Markierung gehörenden Zone (Z1,Z2,Z3) erfolgt.

11. Präsentationssystem nach einem der Ansprüche 9 oder 10, **dadurch gekennzeichnet,**
**dass** die Maske ein Flachbildschirm ist, auf welchem die Markierung oder die Markierungen (M1,M2,M3,M4,M5) dargestellt sind.

12. Präsentationssystem nach einem der Ansprüche 1 bis 11, **dadurch gekennzeichnet,**
**dass** das Display (D) ein LCD-Bildschirm oder ein Plasmabildschirm oder ein sonstiger Flachbildschirm oder ein Kathodenstrahl-Bildschirm oder ein Beamer ist.

13. Präsentationssystem nach den Ansprüchen 11 und 12, **dadurch gekennzeichnet,**
**dass** das Display und die Maske durch ein- und denselben Flachbildschirm gebildet sind.

14. Präsentationssystem nach einem der Ansprüche 1 bis 13, **dadurch gekennzeichnet,**
**dass** an die EDV-Einrichtung (PC) ferner ein Lautsprecher angeschlossen ist,
wobei die EDV-Einrichtung (PC) zusätzlich imstande ist den Lautsprecher zu veranlassen, ein von einem Ort vor der Schaufensterscheibe (S) hörbares akustisches Signal abzugeben, welches der an von der EDV-Einrichtung (PC) an das Display (D) gesandten Information zugeordnet ist.

15. Präsentationssystem nach einem der Ansprüche 1 bis 14, **dadurch gekennzeichnet,**
**dass** die Näherungssensoren (S1,S2,S3,S4,S5) bzw. der ortsauflösende Näherungssensor (OS) mittels wenigstens eines Saugnapfes an der Schaufensterscheibe (S) anordbar sind.

16. Präsentationssystem nach einem der Ansprüche 1 bis 15, **dadurch gekennzeichnet,**
**dass** die Näherungssensoren (S1,S2,S3,S4,S5) bzw. die Zonen (Z1,Z2,Z3) jeweils durch Zwischenräume voneinander beabstandet sind, wobei die Zwischenräume so groß gewählt sind, dass durch ein- und denselben Finger (F) oder ein- und dieselbe Hand jeweils höchstens einer der Näherungssensoren (S1,S2,S3,S4,S5) bzw. jeweils höchstens eine der Zonen (Z1,Z2,Z3) zum Ansprechen gebracht werden kann.

17. Präsentationssystem nach einem der Ansprüche 1 bis 16, **dadurch gekennzeichnet,**
**dass** die Anzahl der Näherungssensoren (S1,S2,S3,S4,S5) bzw. die Anzahl der Zonen (Z1,Z2,Z3) kleiner ist als zehn.
